Europäisches Patentamt

European Patent Office

Office européen des brevets

(19)

(11) Numéro de publication: **0 168 291**
**A1**

(12)

# DEMANDE DE BREVET EUROPEEN

(21) Numéro de dépôt: **85401124.4**

(22) Date de dépôt: **07.06.85**

(51) Int. Cl.⁴: **G 11 C 11/56**
**H 01 L 27/10**

(30) Priorité: **13.06.84 FR 8409202**

(43) Date de publication de la demande:
**15.01.86 Bulletin 86/3**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Berger, Jean-Luc**
**THOMSON-CSF SCPI 173, bld Haussmann**
**F-75379 Paris Cedex 08(FR)**

(72) Inventeur: **Brissot, Louis**
**THOMSON-CSF SCPI 173, bld Haussmann**
**F-75379 Paris Cedex 08(FR)**

(72) Inventeur: **Cazaux, Yvon**
**THOMSON-CSF SCPI 173, bld Haussmann**
**F-75379 Paris Cedex 08(FR)**

(74) Mandataire: **Ruellan-Lemonnier, Brigitte et al,**
**THOMSON-CSF SCPI 173, boulevard Haussmann**
**F-75379 Paris Cedex 08(FR)**

(54) Dispositif mémoire d'image analogique utilisant le transfert de charge.

(57) La présente invention concerne un dispositif mémoire d'image analogique utilisant le transfert de charge.

Le dispositif mémoire comprend:

– une zone mémoire (1) de N lignes de N points mémoire, chaque point mémoire étant constitué par l'intégration sur un même substrat semiconducteur d'une capacité MIS (ST) séparée d'une diode (D) par une grille-écran (G),

– des moyens de sélection de chaque point mémoire $(R_V, T_1, T_2, R_H, T_3 T_4)$,

– des moyens d'inscription $(T_5)$ dans chaque point mémoire d'une quantité de charge correspondant au signal analogique à mémoriser, et,

– des moyens pour lire, ligne par ligne, la zone mémoire après inscription.

Application au stockage d'image vidéo.

EP 0 168 291 A1

./...

# FIG_2

DISPOSITIF MÉMOIRE D'IMAGE ANALOGIQUE
UTILISANT LE TRANSFERT DE CHARGE

La présente invention concerne un dispositif mémoire d'image analogique utilisant le transfert de charge.

Actuellement, les dispositifs réalisant la mise en mémoire d'une image vidéo sont soit des tubes à mémoire soit des mémoires numériques à grande capacité. Dans le cas des tubes à mémoire, l'information est stockée directement sous forme analogique tandis que dans le cas des mémoires numériques, il est nécessaire de transformer l'information analogique en une information numérique, ce qui nécessite une capacité mémoire très importante et un certain nombre de dispositifs de conversion supplémentaires. Or l'homme de métier sait que les dispositifs à transfert de charge sont susceptibles de stocker et de transporter l'information sous forme analogique. Cependant, le temps de stockage maximum d'un dispositif à transfert de charge à la température ordinaire est de l'ordre de 20 à 40ms. En conséquence, des mémoires analogiques susceptibles de stocker des quantités de charge correspondant au signal analogique peuvent être réalisées avec la technologie des transferts de charge à condition de régénérer cycliquement l'information. Une telle régénération peut être effectuée à l'aide de convertisseurs analogiques-numériques et numériques-analogiques. Elle nécessite le stockage d'une information analogique codée, ce qui peut être obtenu facilement dans la technique du transfert de charge en quantifiant les paquets de charge correspondants à l'information analogique. On réalise ainsi des mémoires appelées mémoires analogiques multiniveaux.

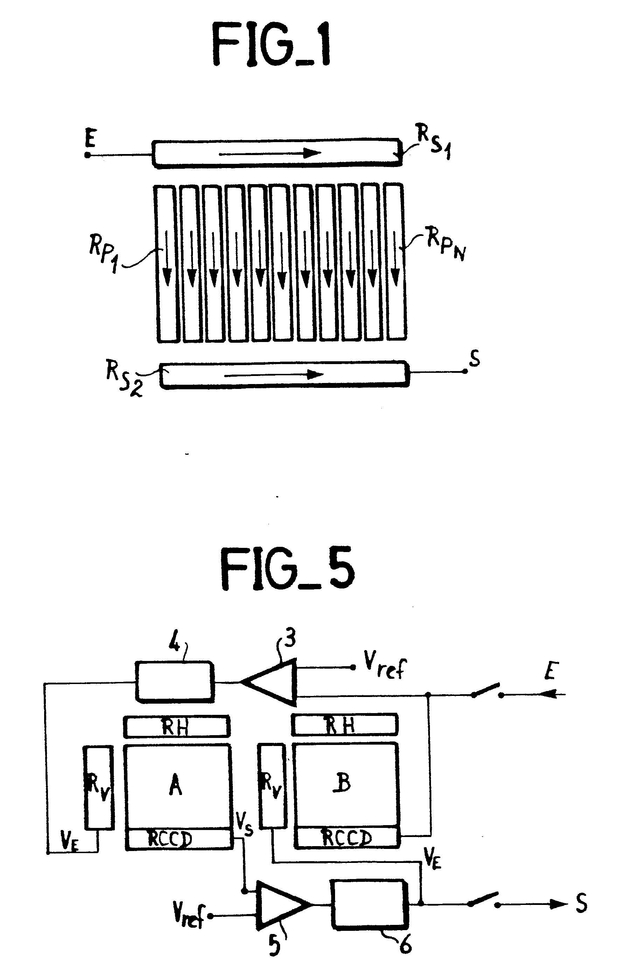

Comme représenté sur la figure 1, les mémoires à transfert de charge à grande capacité capables de stocker une image vidéo, actuellement disponibles sur le marché, sont constituées par :

- un registre d'entrée $R_{S1}$ de type CCD pour "Charge coupled device" en langue anglaise, où les informations sont introduites en série par décalages successifs,

- des registres parallèles $R_{P1}$ à $R_{PN}$ de type CCD, dans lesquels les informations contenues dans le registre d'entrée sont transférées simultanément puis décalées successivement, et

- un registre de sortie $R_{S2}$ de type CCD qui reçoit les informations véhiculées par les registres en parallèle et qui les transmet en série par décalages successifs vers la sortie de la mémoire.

La principale limitation d'une organisation de type série-parallèle-série telle que celle décrite ci-dessus est le grand nombre de transferts à effectuer sur une information analogique. En conséquence, les inefficacités du transfert limitent à trois bits environ la précision du codage, c'est-à-dire, à huit le nombre des niveaux stockés par un étage CCD.

La présente invention a, en conséquence, pour but de présenter une nouvelle organisation pour une mémoire analogique à grande capacité qui ne présente pas ces inconvénients.

La présente invention a pour objet un dispositif mémoire d'image analogique utilisant le transfert de charge comportant :

- une zone mémoire de N lignes de M points-mémoire, chaque point-mémoire étant constitué par l'intégration sur un même substrat semiconducteur d'une capacité MIS séparée d'une diode par une grille-écran,

- des moyens de sélection de chaque point mémoire,

- des moyens d'inscription dans chaque point mémoire d'une quantité de charge correspondant au signal analogique à mémoriser, et,

- des moyens pour lire, ligne par ligne, la zone-mémoire après inscription.

Avec cette organisation, le nombre de transferts de charge est beaucoup plus faible.

D'autre part, la capacité de stockage pour une surface donnée est supérieure. En effet dans l'art antérieur, on est limité par la capacité de stockage des registres CCD. Il en résulte donc la possibilité de stocker un plus grand nombre de niveaux détectables.

D'autres caractéristiques et avantages de la présente invention apparaîtront à la lecture de la description d'un mode de réalisation préférentiel faite avec référence aux dessins ci-annexés dans lesquels :

- la figure 1, déjà décrite, est une représentation schématique d'une mémoire à transfert de charge de l'art antérieur,

- la figure 2 est une vue de dessus schématique d'un dispositif mémoire conforme à la présente invention,

- les figures 3 (a) à 3 (g) sont respectivement une vue en coupe par A-A et B-B de figure 2 et des schémas illustrant l'inscription et la lecture du dispositif mémoire,

- la figure 4 représente certains signaux de commande susceptibles d'être appliqués au dispositif de la figure 2, et,

- la figure 5 est une représentation schématique d'une mémoire permanente utilisant le dispositif-mémoire des figures 2 et 3.

Sur les différentes figures, les mêmes références désignent les mêmes éléments, mais pour des raisons de clarté les cotes et proportions des divers éléments ne sont pas respectées.

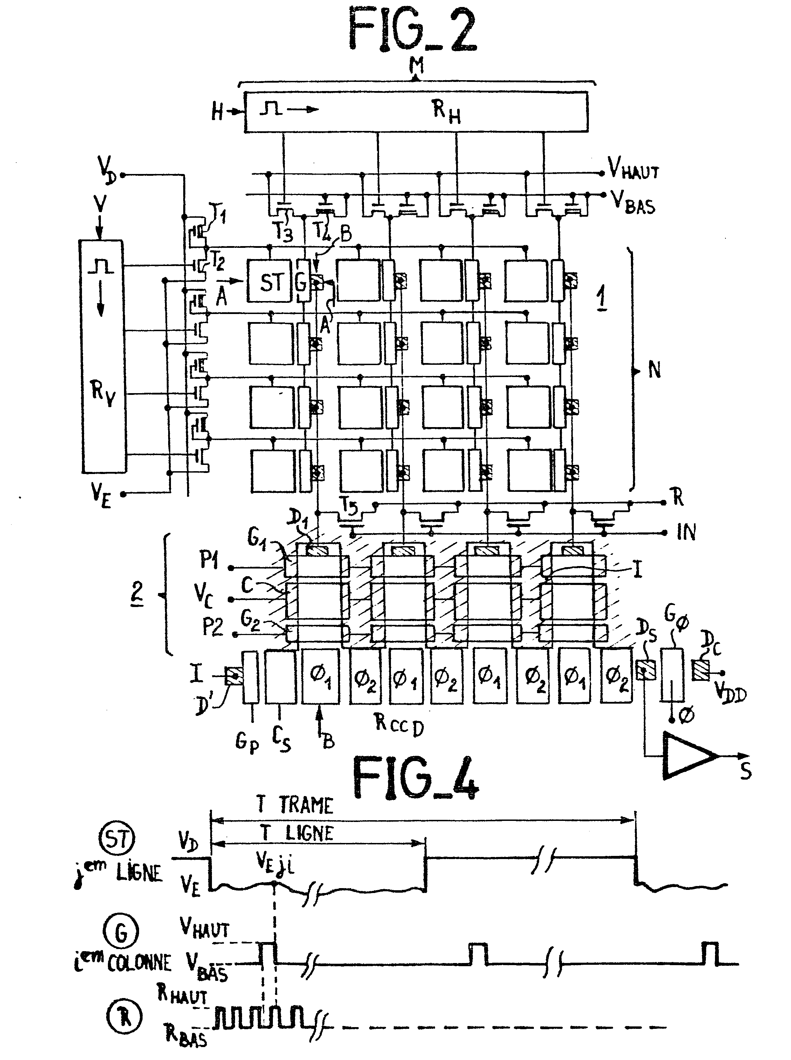

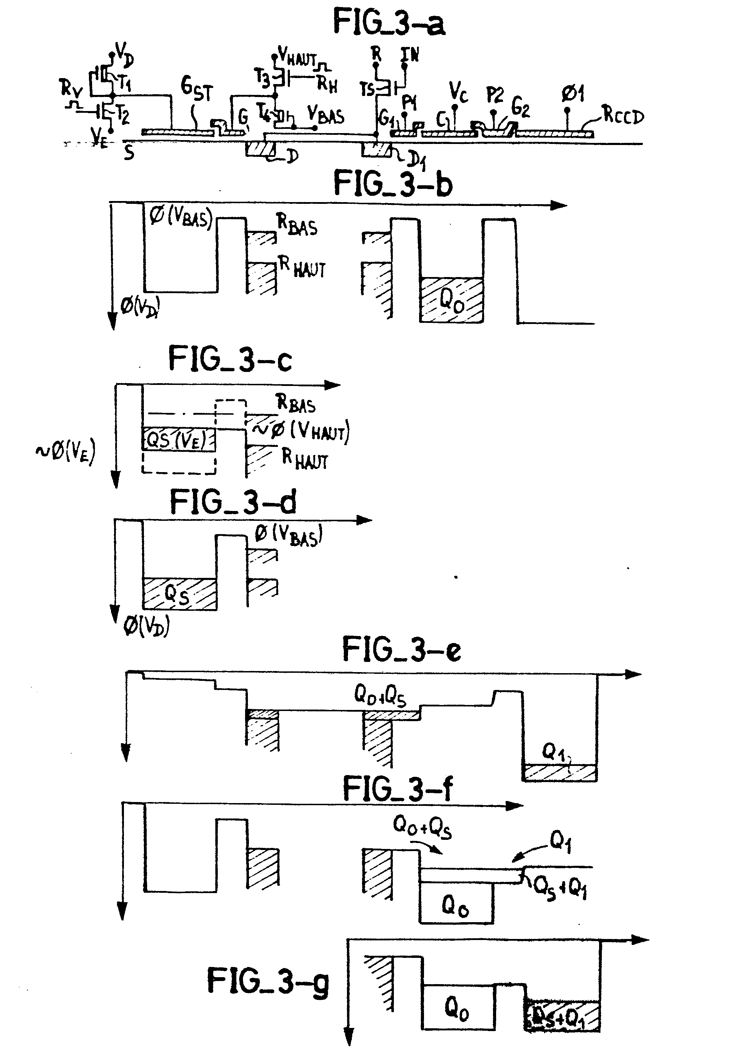

Comme représenté plus particulièrement sur les figures 2 et 3, un dispositif mémoire conforme à la présente invention comporte essentiellement :

- une zone mémoire 1 ;

- des moyens de sélection de chaque point de cette zone mémoire ;

- des moyens d'inscription dans chaque point de la zone mémoire ;

- et des moyens pour lire, ligne par ligne, la zone mémoire après inscription.

On décrira donc successivement chacune de ces parties et on expliquera comment elles sont reliées entre elles.

La zone mémoire 1 est constituée principalement par une matrice de NxM points mémoire. Sur la figure 2, cette matrice comprend quatre lignes et quatre colonnes, c'est-à-dire, seize points mémoire.

Chaque point mémoire est constitué par l'intégration sur un même substrat semiconducteur S, qui est généralement en silicium ; d'une capacité MIS ST formée de manière connue par le substrat, une couche d'isolant tel que de l'oxyde de silicium et une grille $G_{ST}$ en aluminium ou en silicium polycristallin.

Cette capacité ST est associée à une grille écran G qui la sépare d'une diode D utilisée successivement comme diode d'injection de charge et comme diode de lecture comme cela sera expliqué de manière plus détaillée ci-après. De manière connue, la diode D est réalisée par une diffusion de type opposé à celui du substrat.

Comme représenté sur les figures 2 et 3, chaque point mémoire est connecté à des moyens permettant de les sélectionner. De manière plus spécifique, les moyens de sélection de chaque point mémoire sont constitués par des moyens adressant et polarisant ligne par ligne les capacités MIS ST et par des moyens adressant et polarisant colonne par colonne les grilles écran G. Ainsi, les moyens adressant et polarisant ligne par ligne les capacités de stockage ST comportent un registre à décalage logique $R_V$ qui reçoit une impulsion V qui se décale d'un pas à la fréquence ligne lors de l'inscription ou de la lecture de chaque ligne. Le registre à décalage $R_V$ de type série-parallèle comporte N sorties à savoir quatre sorties dans le mode de réalisation de la figure 2. Chaque sortie est connectée à la grille d'un transistor MOS $T_2$ dont une électrode, à savoir le drain dans le mode de réalisation représenté, est reliée au signal analogique à stocker $V_E$ et dont l'autre électrode, à savoir la source, est connectée aux capacités ST d'une même ligne et à un transistor $T_1$ à déplétion monté en charge. Ainsi, de manière connue, le drain du transistor MOS $T_1$ est connecté à une tension de polarisation $V_D$ portée à un niveau haut et la grille du transistor $T_1$ est connectée à sa source.

D'autre part, les moyens adressant et polarisant colonne par colonne les grilles écran G sont constitués essentiellement par un registre à décalage logique $R_H$ série - parallèle dans lequel se déplace une impulsion H à la fréquence point. Les M sorties du registre $R_H$ sont connectées à la grille d'un transistor $T_3$ dont une

électrode, à savoir le drain de ... le mode de réalisation représenté, est connectée à une tension de polarisation $V_{haut}$ et l'autre électrode, à savoir la source du transistor $T_3$ est connectée respectivement aux N grilles écran G d'une même colonne et à un transistor MOS à déplétion $T_4$ dont la grille et une électrode, à savoir le drain, sont reliés à une tension de polarisation $V_{bas}$.

De plus, les moyens d'inscription dans chaque point mémoire permettant d'inscrire une quantité de charge correspondant au signal analogique à mémoriser sont constitués essentiellement par des transistors MOS $T_5$ dont la grille est reliée à un potentiel IN porté au niveau haut uniquement pendant la séquence d'inscription. D'autre part, le drain des transistors MOS $T_5$, dans le mode de réalisation représenté, est relié à un potentiel périodique R qui passe alternativement à un niveau bas et à un niveau haut à la fréquence point et la source des transistors $T_5$ est reliée aux N diodes de chaque colonne.

De plus, le dispositif mémoire conforme à la présente invention comporte des moyens permettant de lire ligne par ligne la zone mémoire après que celle-ci ait été inscrite. Ces moyens sont constitués essentiellement par une mémoire de ligne 2 associée à un registre à décalage à transfert de charge $R_{CCD}$ à entrées parallèles et sortie série. De manière plus spécifique, la mémoire de ligne comporte M capacités de stockage C reliées à un potentiel périodique $V_C$ et séparées par une grille de passage $G_1$ d'une diode de lecture $D_1$ qui est connectée par une connexion aux N diodes D d'une même colonne. D'autre part, la grille $G_1$ est portée à un potentiel $P_1$ permettant le passage des charges stockées dans chaque point mémoire d'une même ligne vers les capacités de stockage C au début de la séquence de lecture comme cela sera expliqué de manière plus détaillée ci-après. De plus, les capacités de stockage C de la mémoire de ligne sont séparées par une grille de passage $G_2$ portée à un potentiel alternatif $P_2$ des M étages d'entrée du registre à décalage $R_{CCD}$. Le registre à décalage de lecture représenté sur la figure 2 est un registre à deux phases de commande $\phi_1$ et $\phi_2$. Ce registre est constitué de manière connue par des couples d'électrodes de stockage et de transfert de charge, connectés successivement à $\phi_1$ et $\phi_2$. Comme représenté sur la figure 2, les électrodes de stockage reliées à $\phi_1$ sont en communication avec les capacités C tandis que des barrières d'isolement I sont prévues en face des couples d'électrodes reliées à $\phi_2$, et séparent les différentes capacités de stockage C les unes des autres. D'autre part, la sortie du registre $R_{CCD}$ est connectée à un étage de lecture proprement dit. Cet étage est un étage réalisant la lecture destructive sur diode flottante et il est constitué essentiellement d'une diode $D_S$, d'une grille $G_\phi$ reliée à un potentiel $\phi$ et d'une diode $D_C$ polarisée par une tension continue $V_{DD}$, la diode $D_S$ étant de plus reliée à un amplificateur donnant en sortie le signal analogique stocké S.

D'autre part, pour pouvoir utiliser des charges d'entraînement lors de la lecture, ce qui améliore l'efficacité du transfert des charges stockées depuis les colonnes conductrices reliant les points mémoire jusqu'au registre de lecture $R_{CCD}$, on prévoit un dispositif d'injection de charge en amont du registre $R_{CCD}$. Ce dispositif d'injection de charge est constitué d'une diode D', d'une grille $G_P$ et d'une grille de stockage $C_S$. Il permet l'injection d'une même charge d'entraînement $Q_1$ dans tous les étages du registre $R_{CCD}$, charge d'entraînement dont le rôle sera expliqué de manière plus détaillée ci-après.

On expliquera maintenant avec référence plus particulièrement aux figures 3(b) à 3(g) et à la figure 4, les séquences d'inscription et de lecture du dispositif mémoire décrit ci-dessus. La figure 4 est un diagramme fonction du temps des signaux appliqués sur une ligne et une colonne pendant la séquence d'inscription. On n'a pas représenté les signaux de la séquence de lecture car ceux-ci sont classiques, le procédé de lecture utilisé étant semblable au procédé de lecture utilisé dans les dispositifs photosensibles dits à transfert de ligne.

Pendant la séquence d'inscription, deux opérations successives sont réalisées :

- adressage d'un point mémoire,

- injection dans le point mémoire d'une quantité de charge proportionnelle au signal analogique à stocker.

Pendant toute la séquence d'inscription, les transistors MOS T5 sont rendus passants en appliquant sur leur grille un potentiel IN porté à un niveau haut.

De ce fait le signal R est alors appliqué en permanence sur les colonnes. Comme représenté sur la figure 4, le signal R est un signal périodique variant entre un niveau bas $R_{bas}$ et un niveau haut $R_{haut}$ à la fréquence point.

D'autre part, le signal analogique à mémoriser est appliqué en permanence sur la connexion d'entrée $V_E$. Pendant la séquence d'inscription, l'ensemble de lecture constitué par la mémoire de ligne 2 et le registre $R_{CCD}$ est verrouillé en portant le potentiel $P_1$ appliqué sur la grille $G_1$ à un niveau bas. De plus, le registre $R_{CCD}$ de lecture ne fonctionne pas.

On donnera tout d'abord le profil de potentiel sous un point mémoire dont ni la ligne ni la colonne ne sont adressées, en se référant à la figure 3(b). Dans ce cas, la capacité ST est portée au potentiel $V_D$ par l'intermédiaire du transistor MOS à déplétion $T_1$ car le transistor MOS $T_2$ est alors bloqué, un niveau "O" étant appliqué sur sa grille. De même, la grille G est portée au potentiel $V_{bas}$ par le transistor MOS à déplétion $T_4$ car le transistor MOS $T_3$ est alors bloqué, un niveau "O" étant aussi appliqué sur sa grille. Il en résulte que le puits de potentiel donné par $\emptyset (V_D)$ sous la capacité ST se trouve isolé par la barrière de potentiel $\emptyset (V_{bas})$ sous la grille G, de la diode D dont le potentiel fluctue entre $R_{bas}$ et $R_{haut}$ en suivant le potentiel de R comme représenté sur la figure 3(b).

Pendant les différentes séquences d'inscription, les potentiels $P_1$ et $P_2$ sont à des niveaux bas tandis que le potentiel $V_C$ est à un niveau haut et l'on obtient les profils de potentiel représentés sur la partie droite de la figure 3(b) correspondant à la partie droite de la figure 3(a).

Lorsqu'une ligne est sélectionnée, c'est-à-dire, lorsque l'impulsion V est appliquée sur la grille du transistor $T_2$ connectée aux capacités ST de ladite ligne, le potentiel de cette ligne suit pratiquement la tension d'entrée $V_E$ appliquée par l'intermédiaire du transistor MOS $T_2$ comme représenté sur la figure 4. En conséquence, tous les points mémoire ST de la ligne suivent la tension $V_E$.

Lorsqu'un point d'une ligne est sélectionné, c'est-à-dire lorsque la grille du transistor MOS $T_3$ de la colonne du point reçoit l'impulsion H, la capacité ST reçoit la tension $V_E$ et la grille G est connectée à $V_{haut}$ par l'intermédiaire du transistor $T_3$. On notera que les transistors MOS $T_2$ et $T_3$ sont beaucoup plus conducteurs que les transistors MOS $T_1$ et $T_4$, ce qui permet d'avoir en sortie les tensions $V_E$ et $V_{haut}$ lorsque les transistors $T_2$ et $T_3$ sont rendus passants.

Lorsque la tension $V_{haut}$ est appliquée sur la grille G, la tension R est au niveau bas comme représenté sur la figure 4 et la diode D injecte des charges sous la capacité ST sélectionnée en imposant le niveau $R_{bas}$ comme représenté à la figure 3(c). Ensuite, la tension R passe au niveau haut et la diode D évacue l'excédent de charge par rapport à la barrière de potentiel sous G donnée par $\phi$ ($V_{haut}$). Une quantité de charge $Q_S$ ($V_E$) proportionnelle à $V_E$ qui fixe le puits de potentiel sous la grille $G_{ST}$, est alors injectée dans la capacité ST selon la méthode d'injection appelée "fill and spill" ou méthode d'injection par écrémage du puits de potentiel.

En fait, la quantité de charge $Q_S$ ($V_E$) injectée de cette façon n'est sensible qu'aux variations relatives de seuil sous la grille écran $G_E$ et la grille $G_{ST}$ de la capacité de stockage. Ces deux grilles étant très proches, si elles sont réalisées sur une même épaisseur d'oxyde, l'influence des variations de seuil est négligeable. Ainsi, pour une même tension $V_E$, les variations de la charge $Q_S$ d'un point mémoire à l'autre dépendent des seules variations de capacités, et donc des conditions de réalisation technologiques.

Si $\Delta Q_S$ est la variation maximum sur une charge injectée $Q_S$ ($V_E$) pour une tension d'entrée $V_E$ constante sur tous les points mémoire, on ne peut lire l'information à mieux que $\Delta Q_S$ près. Le nombre maximum de niveaux que l'on peut alors distinguer et régénérer sur le point mémoire s'écrit : $N = \dfrac{Qmax}{2x\Delta Q_S}$ .

Par exemple, si le point mémoire est capable de stocker $Qmax = 10^6$ électrons avec une variation $\Delta Q_S$ de $10^4$ électrons (1%), le nombre de niveaux repérables est $N = 50$, ce qui fait que $2^5 = 32$

niveaux soit 5 bits, peuvent être mémorisés avec une sécurité suffisante.

Le bruit de lecture et de transfert par transfert de ligne est de l'ordre de 500 électrons, ce bruit est donc négligeable devant le bruit $\Delta Q_S$ et n'affecte pas le nombre de niveaux stockables.

Une fois la colonne inscrite, le potentiel sur la grille écran G est ramené à $V_{bas}$ et une fois l'ensemble de la ligne inscrite le potentiel appliqué sur la grille $G_{ST}$ est ramené à $V_D$. On se retrouve donc dans la situation représentée à la figure 3(d).

On décrira maintenant avec référence aux figures 3(e) à 3(g) la séquence de lecture. Celle-ci s'effectue pour l'ensemble d'une ligne sélectionnée par le registre vertical $R_V$. Pendant la séquence de lecture le transistor MOS $T_5$ est bloqué, le potentiel IN étant au niveau bas. Le niveau $V_{bas}$ est appliqué sur les grilles G car le registre horizontal $R_H$ ne fonctionne pas.

On utilise pour la lecture des charges signal stockées dans les points mémoire, une double charge d'entraînement, à savoir une charge $Q_0$ qui a été stockée et qui est maintenue sous les capacités C de la mémoire de ligne et une charge $Q_1$ qui a été injectée préalablement à la lecture dans le registre de lecture $R_{CCD}$.

Comme représenté sur la figure 3(e) on applique sur l'entrée $V_E$ un potentiel à un niveau bas inférieur à $\emptyset$ ($V_{bas}$) de manière que, lorsque la ligne est sélectionnée, les charges signal $Q_S$ stockées dans le point mémoire ST s'écoulent par dessus la barrière de potentiel sous la grille écran G vers la diode de lecture D où elles viennent s'ajouter à la charge d'entraînement $Q_0$, car simultanément le potentiel $V_C$ appliqué sur la capacité de stockage C est porté à un niveau bas tandis que le potentiel $P_1$ appliqué sur la grille $G_1$ est porté à un niveau haut.

On effectue ensuite le transfert de la charge signal plus la charge d'entraînement $Q_S + Q_0$ sous la capacité C dont le potentiel $V_C$ est ramené à un niveau haut. On porte alors le potentiel $P_2$ à un niveau haut et le potentiel $\emptyset_1$ à un niveau bas pour transférer la seconde charge d'entraînement $Q_1$ depuis le registre CCD sous la capacité C. Le niveau haut du potentiel $P_2$ est choisi de manière à maintenir sous la capacité C uniquement la charge d'entraînement

$Q_0$ comme cela est représenté sur la figure 3(f). Ensuite, le potentiel $Q_1$ est ramené au niveau haut et la charge $Q_S + Q_1$ est transférée dans l'étage correspondant du registre $R_{CCD}$, comme représenté sur la figure 3(g). Le potentiel $P_2$ est alors ramené à un niveau bas et le registre $R_{CCD}$ effectue le transfert des charges $Q_S + Q_1$ vers l'étage de lecture de la manière connue.

On utilise dans le mode de réalisation ci-dessus un procédé de lecture avec deux charges d'entraînement, toutefois il est évident pour l'homme de l'art que d'autres procédés de lecture identiques aux procédés de lecture d'un dispositif photosensible du type à transfert de ligne peuvent être utilisés sans sortir du cadre de la présente invention. Il en résulte que la structure des moyens de lecture ligne par ligne peut être elle aussi modifiée sans sortir du cadre de l'invention.

Le dispositif mémoire décrit ci-dessus comporte en sortie du registre de lecture CCD un comparateur qui repère les niveaux et les régénère pour fournir le signal analogique stocké. En conséquence, pour respecter le nombre de niveaux, l'inefficacité de transfert vertical doit être inférieure à $\frac{1}{2N}$.

Pour réaliser une mémoire permanente dont le temps de stockage est supérieur à 40 millisecondes, deux dispositifs mémoires tels que décrit ci-dessus sont nécessaires. Ces dispositifs mémoires travaillent alternativement en lecture et en inscription car les deux opérations ne sont pas simultanées. Les deux dispositifs mémoires sont assemblés de la manière représentée à la figure 5.

L'information analogique E est introduite à travers N comparateurs 3 qui la codent en N niveaux par le dispositif de régénération 4 qui charge ainsi la mémoire A. Celle-ci est ensuite lue et charge simultanément la mémoire B à travers N comparateurs 5 et un dispositif de régénération des niveaux 6 puis B recharge A et ainsi de suite.

REVENDICATIONS

1. Dispositif mémoire d'image analogique utilisant le transfert de charge caractérisé en ce qu'il comporte :
- une zone mémoire (1) de N lignes de M points mémoire, chaque point mémoire étant constitué par l'intégration sur un même substrat semiconducteur d'une capacité MIS (ST) séparée d'une diode (D) par une grille écran (G),
- des moyens de sélection de chaque point mémoire, $(R_V, T_1, T_2, R_H, T_3, T_4)$,
- des moyens d'inscription $(T_5)$ dans chaque point mémoire d'une quantité de charge correspondant au signal analogique à mémoriser, et,
- des moyens pour lire $(2, R_{CCD})$, ligne par ligne, la zone mémoire après inscription.

2. Dispositif mémoire selon la revendication 1 caractérisé en ce que les moyens de sélection de chaque point mémoire sont constitués par des moyens $(R_V, T_1, T_2)$ adressant et polarisant, ligne par ligne, les capacités MIS et par des moyens $(R_H, T_3, T_4)$ adressant et polarisant colonne par colonne les grilles écran.

3. Dispositif mémoire selon la revendication 2 caractérisé en ce que les moyens adressant et polarisant ligne par ligne les capacités MIS comportent un registre à décalage logique $(R_V)$ à N sorties, chaque sortie étant reliée à la grille d'un transistor MOS $(T_2)$ dont une électrode est reliée à une charge $(T_1)$ polarisée à un niveau haut et aux capacités MIS (ST) d'une même ligne et dont l'autre électrode reçoit le signal analogique $(V_E)$ à stocker.

4. Dispositif mémoire selon la revendication 2 caractérisé en ce que les moyens adressant et polarisant colonne par colonne les grilles-écran comportent un registre à décalage logique $(R_H)$ à M sorties, chaque sortie étant reliée à la grille d'un transistor

MOS($T_3$) dont une électrode est reliée à une charge ($T_4$) imposant un niveau bas et aux grilles-écran (G) d'une même colonne et dont l'autre électrode reçoit un niveau haut.

5. Dispositif-mémoire selon la revendication 1 caractérisé en ce que les moyens d'inscription dans chaque point mémoire d'une quantité de charge correspondant au signal analogique à mémoriser sont constitués par des dispositifs permettant l'injection de charge par écrémage du puits de potentiel créé sous les capacités MIS.

6. Dispositif-mémoire selon la revendication 5 caractérisé en ce que les moyens d'inscription dans chaque point-mémoire d'une quantité de charge correspondant au signal analogique à mémoriser comportent des transistors MOS ($T_5$) adressant chaque colonne de diodes (D) dont la grille est connectée à un potentiel périodique (IN) rendant les transistors MOS passant pendant la séquence d'inscription et dont une électrode reçoit un signal périodique (R) variant entre un niveau haut et un niveau bas à la fréquence point.

7. Dispositif-mémoire selon la revendication 1 caractérisé en ce que les moyens pour lire ligne par ligne la zone mémoire après inscription sont constitués par une mémoire (2) de M points, dite mémoire de ligne, dont chaque point est connecté aux N diodes (D) d'une même ligne et par un registre $R_{CCD}$ à décalage analogique, recevant en parallèle les charges fournies par la mémoire de ligne et les délivrant en série vers un étage de lecture donnant en sortie le signal analogique ($V_E$) précédemment stocké.

8. Dispositif mémoire selon la revendication 7 caractérisé en ce que la mémoire de ligne est constituée par M capacités (C) de stockage, chaque capacité étant reliée d'une part aux N diodes (D) d'une même colonne par l'intermédiaire d'une diode de lecture ($D_1$) et d'une grille de passage ($G_1$) portée à un niveau haut pendant la séquence de lecture et d'autre part à une entrée du registre (RCCD) à décalage analogique par l'intermédiaire d'une seconde grille de passage ($G_2$) reliée à un potentiel périodique.

9. Dispositif mémoire selon la revendication 7 caractérisé en ce qu'il comporte des moyens (D',$G_p$, $C_S$) permettant d'injecter des charges d'entraînement dans la mémoire de ligne.

10. Dispositif mémoire selon la revendication 8 caractérisé en ce qu'il comporte des moyens (D', $G_p$, $C_S$) permettant d'injecter des charges d'entraînement dans la mémoire de ligne.

11. Dispositif mémoire selon la revendication 9 caractérise en ce qu'un dispositif d'injection d'une charge en série est associé au registre à décalage analogique.

12. Dispositif mémoire selon la revendication 10 caractérisé en ce qu'un dispositif d'injection d'une charge en série est associé au registre à décalage analogique.

13. Dispositif mémoire selon la revendication 1 caractérisé en ce que le signal analogique à stocker est un signal analogique codé suivant plusieurs niveaux.

14. Mémoire permanente caractérisée en ce qu'elle est constituée par deux dispositifs mémoire (A,B) selon la revendication 1, la sortie de chaque dispositif mémoire étant connectée à l'entrée de l'autre dispositif mémoire par l'intermédiaire d'un dispositif de régénération des niveaux (3,4,5,6).

# FIG_1

$E$     $R_{S_1}$

$R_{P_1}$     $R_{P_N}$

$R_{S_2}$     $S$

# FIG_5

4    3    $V_{ref}$    $E$

RH    RH

$R_V$   A    $R_V$   B

$V_E$   RCCD   $V_S$   RCCD

   $V_E$

$V_{ref}$   5   6   $S$

0168291

2/3

FIG_2

FIG_4

3/3

0168291

FIG_3-a

FIG_3-b

FIG_3-c

FIG_3-d

FIG_3-e

FIG_3-f

FIG_3-g

Office euro éen
des brevets

**RAPPORT DE RECHERCHE EUROPEENNE**

0168291
Numéro de la demande

EP 85 40 1124

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int. Cl.4) |
|---|---|---|---|
| A | IEEE JOURNAL OF SOLID-STATE CIRCUITS, vol. SC-11, no. 4, août 1976, pages 519-528, IEEE, New York, US; R.A. HEALD et al.: "Multilevel random-access momory using one transistor per cell" * Page 526, colonne de droite, lignes 21-50 * | 1,13 | G 11 C 11/56 H 01 L 27/10 |
| A | US-A-4 395 764 (SHIGEKI MATSUE) * Colonne 6, ligne 20 - colonne 11, ligne 8 * | 1-4 | |
| A | NEC RESEARCH AND DEVELOPMENT, no. 12, octobre 1968, pages 29-36, Tokyo, JP; O. ENOMOTO et al.: "Most capacitor memory" * Page 31, colonne de gauche, ligne 1 - page 33, colonne de droite, ligne 9; page 35, colonne de gauche, ligne 1 - colonne de droite, ligne 14 * | 1,13 | **DOMAINES TECHNIQUES RECHERCHES (Int. Cl.4)** |
| A | US-A-4 417 325 (E. HARARI) * Colonne 14, ligne 52 - colonne 15, ligne 11 * | 1,13 | G 11 C H 01 L H 04 N |
| A | EP-A-0 064 890 (THOMSON-CSF) * Page 4, ligne 16 - page 6, ligne 3; page 25, lignes 23-25 * | 7,8 | |

--- -/-

Le présent rapport de recherche a été établi pour toutes les revendications

| Lieu de la recherche | Date d'achèvement de la recherche | Examinateur |
|---|---|---|
| LA HAYE | 23-09-1985 | VERSCHELDEN J. |

# RAPPORT DE RECHERCHE EUROPEENNE

**Office européen des brevets**

**0168291**
Numéro de la demande

EP 85 40 1124

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | US-A-4 209 852 (G. HYATT) <br> * Colonne 8, ligne 35 - colonne 9, ligne 46 * | 14 | |
| A | EP-A-0 038 725 (THOMSON-CSF) | | |
| A | EP-A-0 060 752 (THOMSON-CSF) | | |
| A | US-A-4 272 831 (M. ULLRICH) | | |
| A | US-A-4 126 899 (J. LOHSTROH) | | |
| | ----- | | **DOMAINES TECHNIQUES RECHERCHES (Int. Cl.4)** |

Le présent rapport de recherche a été établi pour toutes les revendications

| Lieu de la recherche <br> LA HAYE | Date d'achèvement de la recherche <br> 23-09-1985 | Examinateur <br> VERSCHELDEN J. |
|---|---|---|

OEB Form 1503 03 82

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant